Europäisches Patentamt

European Patent Office

Office européen des brevets

(19)

(11) Veroffentlichungsnummer: **0 136 494**
A1

(12) **EUROPÄISCHE PATENTANMELDUNG**

(21) Anmeldenummer: **84109665.4**

(22) Anmeldetag: **14.08.84**

(51) Int Cl.⁴: **H 01 L 21/306**
**H 01 L 29/201, H 01 L 29/10**

(30) Priorität: **23.08.83 GB 8322625**

(43) Veröffentlichungstag der Anmeldung:
**10.04.85 Patentblatt 85/15**

(84) Benannte Vertragsstaaten:
**BE DE FR IT NL**

(71) Anmelder: **Deutsche ITT Industries GmbH
Hans-Bunte-Strasse 19 Postfach 840
D-7800 Freiburg(DE)**

(84) Benannte Vertragsstaaten:
**DE**

(71) Anmelder: **ITT INDUSTRIES INC.
320 Park Avenue
New York, NY 10022(US)**

(84) Benannte Vertragsstaaten:
**BE FR IT NL**

(72) Erfinder: **Thompson, George Horace Brooke
20 Hoestock Road
Sawbridgeworth Herts(GB)**

(72) Erfinder: **Dawe, Piers James Geoffrey
Grooms House Willingdon School of Riding
Churchgate Street Harlow(GB)**

(74) Vertreter: **Morstadt, Volker, Dipl.-Ing.
c/o Deutsche ITT Industries GmbH Patent/lizenzabteilung
Postfach 840 Hans-Bunte-Strasse 19
D-7800 Freiburg/Brsg.(DE)**

(54) **Gallium-Indium-Arsenid-Feldeffekttransistor.**

(57) Das Gate eines Gallium-Indium-Arsenid-Feldeffekt-
transistors, aufgebaut auf einem Indiumphosphidsubstrat,
umfaßt eine obere Schicht (6) aus Gallium-Indium-Arsenid-
Phosphid (Bandabstand 1, 2 eV), eine mittlere Schicht (5) aus
Gallium-Indium-Arsenid und eine untere Schicht (4) aus
Indiumphosphid. Dieser Aufbau läßt sich unter Ausbildung
einer überhängenden Oberschicht ätzen, was eine selbstausrichtende Gate-Kontakt-Metallisierung erlaubt, wobei die
Ausrichtungsprobleme von einer weiteren Maskenstufe vermieden werden.

Fig. 4.

EP 0 136 494 A1

G.H.B Thompson 33-1

FL 1236 EP **0136494**
Dr.Rl/Be
9. August 1984

## Gallium-Indium-Arsenid-Feldeffektransistor

Die Priorität der Anmeldung Nr. 8322625 vom 23. August
1983 in Großbritannien wird beansprucht.

Die Erfindung betrifft die Herstellung von Gallium-
Indium-Arsenid-Feldeffektransistoren und insbesondere
die Verwendung einer Struktur, die zur Bildung eines
selbstausrichtenden Gates geeignet ist.

Bei der Herstellung von Feldeffekttransistoren ist
eine der üblichen Forderungen, daß die Gatelänge so
kurz wie möglich sein soll, und für bestimmte Anwendungen ist eine Gatelänge unterhalb von 1 $\mu$m erwünscht.
Unter diesem Umständen wird die Maskenausrichtung
schwierig, wenn man nicht auf irgend eine Form der
Selbstausrichtungstechnik zurückgreifen kann. Im Falle
von Galliumarsenid-Feldeffektransistoren wurde eine
derartige Technik von S. Umebachi et al in einem Aufsatz mit dem Titel "A New Heterojunction Gate GaAs
FET" beschrieben, erschienen in "IEEE Transaction
on Electron Devices", Vol. ED-22, Seiten 613 bis 614,
(August 1975).

Dabei wird bei einem Galliumarsenid-Feldeffekttransistor
eine selbstausrichtenden Gatestruktur erzeugt, indem
man das Gate aus einer Doppelschicht herstellt, und zwar
mit einer unteren Schicht aus p-leitendem Gallium-Aluminium-Arsenid und einer darüberliegenden Schicht aus
p-leitendem Galliumarsenid. Man benutzt dann einen
Ätzvorgang, der nur das Gallium-Aluminium- Arsenid und
nicht das Galliumarsenid angreift, so daß die obere Schicht unterätzt und ein "Mushroom" erzeugt wird, dessen Überhang dazu dient, die nachfolgende Metallisierung in elektrisch isolierte Source-, Gate- und Drain-Zonen zu trennen. Es konnten jedoch keine entsprechenden Strukturen für einen Gallium- Indium-Arsenid-Feldeffekttransistor gefunden werden, mit einer Zusammensetzung, die eine Gitterkonstante ergibt, die im wesentlichen mit der von Indiumphosphid übereinstimmmt. Die Erzeugung der Gallium-Aluminium-Arsenidschicht bei dem Feldeffekttransistor nach dem Stand der Technik beruht auf dem selektiven Ätzvorgang, der durch das Ätzen von Gallium-Aluminium-Arsenid, wobei Galliumarsenid im wesentlichen unangegriffen bleibt, ein Unterätzen erzeugt. Es ist ferner vorteilhaft, daß das Gallium-Aluminium-Arsenid einen größeren Bandabstand besitzt als das darunterliegende Material des Kanal des Feldeffekttransistors. Es nicht ist gelungen, für einen Gallium-Indium-Arsenid-Feldeffekttransistor ein Material zu finden, das sich selektiv in der obigen Weise ätzen läßt, so daß die darunterliegende Gallium-Indium-Arsenidschicht von entgegengesetzter Leitfähigkeit im wesentlichen unberührt bleibt.

Hier will die Erfindung Abhilfe schaffen. Die Erfindung, wie sie in den Ansprüchen gekennzeichnet ist, löst die Aufgabe, einen Gallium-Indium-Arsenid-Feldeffekttransistor mit selbstausrichtenden Gate zu schaffen, dessen Zusammensetzung eine dem Indiumphosphid weitgehend angepaßte Gitterkonstante ergibt. Die durch die Erfindung erreichten Vorteile sind in der Lösung der Aufgabe zu sehen und ferner in dem Verfahren, das die Herstellung eines derartigen Feldeffekttransistors ermöglicht.

Es hat sich gezeigt, daß in dem Zusammensetzungsbereich mit passenden Gitterkonstanten von Indiumphosphid über Gallium-Indium-Arsenidphosphid zu Gallium-Indium-Arsenid ein erster Bereich an Zusammensetzungen existiert, der auf einen ersten Ätztyp selektiv reagiert, daß ein zweiter Bereich existiert, der gegenüber einen zweiten unterschiedlichen Ätztyp selektiv reagiert und daß ein Zwischenbereich existiert, der auf keinen der Ätztypen reagiert. Es hat sich ferner gezeigt, daß durch Anwendung dieser Zusammensetzungen und Ätztypen es möglich ist, unterätzte Strukturen zu erzeugen.

Durch die vorliegende Erfindung wird ein Gallium-Indium-Arsenid-Feldeffekttransistor mit selbstausrichtendem Gate geschaffen, dessen Aufbau eine Gitterkonstante ergibt, die mit der von Indiumphosphid weitgehend übereinstimmt, wobei bei dem Feldeffekttransistor das Gate durch drei übereinanderliegende Schichten gleicher Leitfähigkeit auf einer Schicht aus Gallium-Indium-Arsenid von entgegengesetzter Leitfähigkeit gebildet wird. Die Zusammensetzungen der drei Schichten liegen im Bereich zwischen Indiumphosphid über Gallium-Indium-Arsenidphosphid bis Gallium-Indium-Arsenid und zwar so, daß die oberste Schicht einen Bandabstand im Bereich von 1,2 Ev aufweist, die unterste einen wesentlich höheren Bandabstand und die mittlere Schicht einen wesentlich niedrigeren Bandabstand.

Die Herstellung eines derartigen Feldeffekttransistors umfaßt einen photolithographischen Ätzvorgang, bei dem die oberste und die mittlere Schicht gänzlich durchgeätzt, die unterste Schicht jedoch nur zum Teil geätzt wird, so daß ein Streifen definiert wird, der zur Ausbildung des Gate des Feldeffekttransistors bestimmt ist. Der Ätzvorgang wird dabei in eine erste selektive Ätzung abgeändert, die die oberste Schicht unterätzt, dann wird dieser Ätzvorgang in eine zweite selektive Ätzung abgeändert, die die unterste Schicht ätzt, gegen die die Gallium-Indium-Arsenidschicht entgegengesetzter Leitfähigkeit jedoch beständig ist. Eine Metallschicht wird dabei auf der geätzten Oberfläche abgeschieden, die durch das Unterätzen eine von der Sourcekontaktzone und der Drainkontaktzone isolierte Gatekontaktzone bildet.

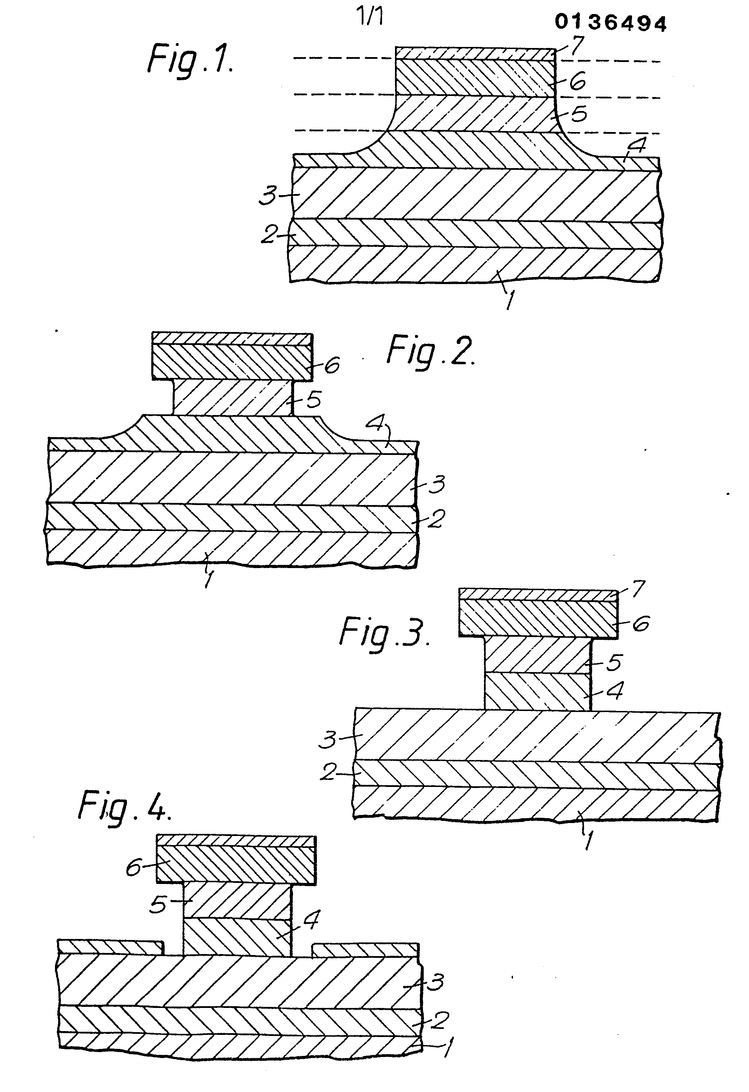

Die Erfindung wird nachstehend anhand eines in den Figuren der Zeichnung dargestellten Ausführungsbeispiels näher erläutert. Die Fig. 1 bis 4 stellen dabei Schnitte durch die aufeinanderfolgenden Herstellungsstufen des Bauelements dar.

Fünf in ihren Gittern zusammenpassenden Gitterschichten werden auf einen Indiumphosphidsubstrat 1 aufwachsen gelassen. Die erste Epitaxschicht ist eine dünne schwach—dotierte oder halbleitende Pufferschicht 2 aus Gallium-Indium-Arsenid mit der Stärke 0,05 $\mu$m. Diese wird von einer n-leitenden Schicht 3 aus Gallium-Indium-Arsenid mit der Stärke 0,2 um bedeckt, die die Kanalschicht des Feldeffekttransistors bildet.

Die Schicht 3 wird von der p-leitenden Schicht 4 bedeckt, die mit der Schicht 3 den PN-Übergang des Feldeffekttransistors bildet. Die Schicht 4 wird von zwei weiteren p-leitenden Schichten 5 und 6 bedeckt, deren Zusammensetzung im Hinblick auf die der Schicht 4 so gewählt ist, daß es möglich ist, die drei Schichten derart zu ätzen, daß ein Unterätzen eintritt, so daß nachfolgend ein selbstausrichtender Prozess angewendet werden kann, um die Metallkontakte für die drei Anschlüsse des Feldeffekttransistors herzustellen. Für den Bereich der bezüglich ihrer Gitter angepaßten Zusammensetzungen von Indiumphosphid über Gallium-Indium-Arsenidphosphid zu Gallium- Indium-Arsenid bestehen Ätzmöglichkeiten für das Gallium-Indium-Arsenid, aber dessen Ätzraten gehen mit ansteigendem Indiumphosphid-Gehalt stark zurück, und zwar bis auf Null herunter in der Zeit, in der der Bandabstand des Materials sich von 0,7 eV, Gallium-Indium-Arsenid bis in den Bereich von 1,15 eV erhöht hat. Ähnlich gibt es andere Ätzungen für Indiumphosphid, aber dessen Ätzraten werden mit ansteigendem Gallium-Arsenidgehalt ebenfalls bis auf Null veringert, innerhalb der Zeit, in der der Bandabstand des Materials sich von 1,35 eV (Indiumphosphid) bis in den Bereich von 1,2 eV verringert hat. Als Beispiel für den ersten Ätztyp ist das Ätzen mit Eisen-III-Zyanid genannt als Beispiel für den zweiten Ätztyp das Ätzen mit HCL/Phosphorsäure. Dies läßt Gallium-Indium-Arsenid-phosphid-Zusammensetzungen mit Bandabständen um 1,2 eV gegenüber beiden Ätzungen resistent. Die Schicht 6 ist deshalb aus dieser ätzbeständigen Zusammensetzung aufgebaut, wohingegen die Schicht 5 aus einem ternären oder quaternären Material besteht, das hinreichend durch Eisen-III-Zyanid geätzt wird. Die Schicht 4 aus Indiumphosphid läßt sich mit Salzsäure/Phosphorsäure ätzen (die Schicht 4 kann gegebenenfalls aus quaternären Material bestehen, vorausgesetzt der Anteil an Gallium-Arsenid ist hinreichend klein). Jede dieser drei p-leitenden Schichten ist ca. 0,3 um dick.

Die herkömmlichen Photolithographietechniken werden bei der Maskenherstellung für das Ätzen angewendet. Unter Verwendung einer Maskierschicht 7 (Fig. 1) wird die erste Ätzstufe unter Verwendung eines starken

G.H.B. Thompson et al 33-1                    Fl 1226 EP

Ätzmittels wie Bor/Methanol vorgenommen, wodurch der gesamte Bereich an Substanzen von Indiumphosphid bis Gallium-Indium-Arsenid geätzt wird. Der Ätzvorgang bricht ab sobald die p-leitende Indiumphosphidschicht 4 erreicht ist (Fig.1). Der Ätzvorgang erzeugt ein vernachlässigbares Unterätzen und er wird gefolgt durch ein Ätzen mit Eisen-III-Zyanid, wodurch die Kanten der Schicht 6, wie in Fig. 2 gezeigt, unterätzt werden. Ein dritter Ätzvorgang schließt sich an. Dieser wird mit Salzsäure/Phosphorsäure vorgenommen, wobei Indium-Gallium-Arsenid-Phosphid nicht unter ätzt wird, er dient jedoch zur Entfernung des Rests der Indiumphosphidschicht 4, der nicht durch die verbleibenden Teile der quaternären Schicht 5 maskiert ist, wie Fig. 3 zeigt. Dieser Aufbau der Halbleiterschichten eignet sich für eine nachfolgende Matalliesierung, bei der der Überhang auf jeder Seite die Metallisierungsschicht in drei bestimmten Zonen 9, 10 und 11 trennt, wie Fig. 4 zeigt.

Das vorhergehende Beispiel bezieht sich auf einen Feldeffekttransistor, der auf einem Indiumphosphidsubstrat aufgebaut ist. Es liegt auf der Hand, daß ähnliche Feldeffekttransistoren in gleicher Weise auf anderen Substraten mit gleichermaßen geringer unterschiedlicher Gitterkonstante aufgebaut werden können. Es ist dann lediglich erforderlich, geringe Veränderungen in den Zusammensetzungen der Epitaxschichten vorzunehmen, um diese der neuen Gitterkonstante anzupassen.

Es liegt ferner auf der Hand, daß die Erfindung auch auf die Herstellung von integrierten Schaltungen übertragen werden kann, die ein oder mehrere Feldeffekttransistoren des beschriebenen Typs enthalten, obwohl die Beschreibung sich auf die Herstellung eines diskreten Feldeffektransistors bezieht.

G.H.B. Thompson et al 33-1          Fl 1226 0136494
                                    Dr. Rl/Be
                                    9. August 1984

Patentansprüche

1. Gallium-Indium-Arsenid-Feldeffekttransistor mit
   selbstausrichtendem Gate und einer Zusammensetzung,
   die eine dem Indiumphosphid entsprechende Gitterkonstante gewährleistet, dadurch gekennzeichnet,
   daß das Gate des Feldeffekttransistors durch drei
   Schichten (4, 5, 6) der gleichen Leitfähigkeit auf
   einer Schicht (3) von Gallium-Indium-Arsenid  entgegengesetzten Leitfähigkeit gebildet ist, wobei die
   Zusammensetzungen der drei Schichten in dem Bereich
   von Indiumphosphid über Gallium-Indium-Arsenid-Phosphid zu Gallium-Indium-Arsenid liegen und so sind,
   daß die oberste Schicht (6) einen Bandabstand im
   Bereich von 1,2 eV, die unterste Schicht (4) einen
   wesentlich höheren Bandabstand und die mittlere
   Schicht (5) einen wesentlich niedrigeren Bandabstand
   aufweist.

2. Verfahren zum Herstellen eines Feldeffekttransistors
   nach Anspruch 1, dadurch gekennzeichnet, daß unter
   Zuhilfenahme von Photolithographie die oberste
   und die mittlere Schicht gänzlich, die unterste
   Schicht (4)nur zum Teil durchgeätzt wird unter
   Ausbildung einer Rippe, die zur Bildung des Gates des
   Feldeffekttransistors bestimmt ist, wobei das Ätzen
   in einen ersten selektiven Ätzvorgang abgeändert
   wird, der die oberste Schicht (6) unterätzt, daß
   dieser erste selektive Ätzvorgang dann in einen
   zweiten selektiven Ätzvorgang abgeändert wird, gegen
   den die Gallium-Indium-Arsenid-Schicht (3) entgegengesetzter Leitfähigkeit resistent ist und der die
   unterste Schicht (4) ohne Unterätzen ätzt, daß ferner
   eine Metallschicht auf der geätzten Oberfläche aufgebracht wird, durch die in Verbindung mit der Unterätzung eine Gatekontaktzone ausgebildet wird, die von der Sourcekontakt- und Drainkontakt-Zone elektrisch isoliert ist.

3. Verfahren nach Anspruch 2, dadurch gekennzeichnet, daß der erste Ätzschritt mit Brom/Methanol ausgeführt wird.

4. Verfahren nach den Ansprüchen 2 oder 3, dadurch gekennzeichnet, daß der erste selektive Ätzvorgang mit Eisen-III-Zyanid ausgeführt wird.

5. Verfahren nach einem der vorhergehenden Ansprüche, dadurch gekennzeichnet, daß der zweite selektive Ätzschritt mit Salzsäure/Phosphorsäure durchgeführt wird.

1/1     0136494

Fig.1.

Fig.2.

Fig.3.

Fig.4.

Europäisches
Patentamt

**EUROPÄISCHER RECHERCHENBERICHT**

**0136494**
Nummer der Anmeldung

EP 84 10 9665

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | GB-A-1 434 308 (STANDARD) <br> * Anspruch 1; Seite 2, Zeilen 42-49; Figur 1 * | 1 | H 01 L 21/306 <br> H 01 L 29/201 <br> H 01 L 29/10 |
| | --- | | |
| A | US-A-4 049 488 (PHILIPS) <br> * Ansprüche 1,8; Spalte 4, Zeile 66 - Spalte 5, Zeile 9; Figuren 1-4 * | 2,4 | |
| | --- | | |
| A | WO-A-8 300 073 (WESTERN ELECTRIC) <br> * Ansprüche 1,2; Seite 8, Zeilen 1-16; Seite 9, Zeilen 9-34; Figuren 1-7 * | 2,5 | |
| | --- | | |
| A | DE-B-2 517 049 (MATSUSHITA) <br><br> * Ansprüche 1,2; Spalte 2, Zeile 40 - Spalte 3, Zeile 8; Figuren 1,2A - 2C * | | RECHERCHIERTE SACHGEBIETE (Int. Cl.4) |
| | --- | | |
| A | JOURNAL OF THE ELECTROCHEMICAL SOCIETY Band 129, Nr.5, Mai 1982, New Hampshire, USA; S. ADACHI et al: "Chemical Etching of InGaAsP/InP DH Wafer", Seiten 1053-1062 | 2,3 | H 01 L 21/306 <br> H 01 L 29/10 <br> H 01 L 29/20 |
| | ---      -/- | | |

Der vorliegende Recherchenbericht wurde für alle Patentansprüche erstellt.

| Recherchenort | Abschlußdatum der Recherche | Prüfer |
|---|---|---|
| BERLIN | 12-11-1984 | ROTHER A H J |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument

EPA Form 1503 03.82

# Europäisches Patentamt
# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | JOURNAL OF THE ELECTROCHEMICAL SOCIETY, Band 129, Nr.3, März 1982, New Hampshire, USA; S. ADACHI : "Chemical Etching of InP and InGaAsP/InP", Seiten 609-613 | 2 | |
| A | IEEE ELECTRON DEVICE LETTERS, Band EDL-1, Nr. 6, Juni 1980, New York, USA; R.F. LEHENY et al: "An In0,53 Ga0,47As Junction Field-Effect Transistor", Seiten 110-111 | | |

RECHERCHIERTE SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| BERLIN | 12-11-1984 | ROTHER A H J |